Europäisches Patentamt

European Patent Office

Office européen des brevets

(11) Numéro de publication: **0 498 328 A1**

## (12) DEMANDE DE BREVET EUROPEEN

(21) Numéro de dépôt: **92101698.6**

(22) Date de dépôt: **03.02.92**

(51) Int. Cl.5: **H03H 11/20**

(30) Priorité: **06.02.91 FR 9101314**

(43) Date de publication de la demande:
**12.08.92 Bulletin 92/33**

(84) Etats contractants désignés:
**DE FR GB IT SE**

(71) Demandeur: **ALCATEL ESPACE**
**11, avenue Dubonnet**
**F-92407 Courbevoie Cédex(FR)**

(72) Inventeur: **Cazaux, Jean-Louis**
**3, rue Renaudot**
**F-31100 Toulouse(FR)**
Inventeur: **Perichon, Robert-Alain**
**c/o Alcatel Espace, B.P. 1187**
**F-31037 Toulouse Cedex(FR)**

(74) Mandataire: **Weinmiller, Jürgen et al**
**Lennéstrasse 9 Postfach 24**
**W-8133 Feldafing(DE)**

(54) **Déphaseur variable analogique pour signaux hyperfréquence.**

(57) Ce déphaseur comporte un circuit déphaseur proprement dit (1), comportant lui-même un transistor contre-réactionné au moyen d'une réactance variable (L3, T5), et des circuits actifs d'adaptation d'entrée (2) et de sortie (3).

FIG. 2

EP 0 498 328 A1

EP 0 498 328 A1

La présente invention concerne un déphaseur variable analogique pour signaux hyperfréquence.

De tels déphaseurs peuvent être utilisés notamment dans des antennes du type réseau qui comportent des éléments de réglage du faisceau émis ou reçu par ces antennes, comportant eux-mêmes un ensemble de modules élémentaires, espacés d'une distance appelée pas du réseau, pour le réglage de la phase et de l'amplitude des signaux hyperfréquence qu'ils reçoivent.

Pour des applications spatiales, et plus particulièrement pour des équipements spatiaux utilisant des antennes du type réseau dans leur version miniaturisée appelée antenne active, il est nécessaire d'obtenir une miniaturisation aussi poussée que possible de ces modules élémentaires et notamment de leurs circuits élémentaires de réglage de phase, tout en conservant une précision de réglage aussi fine que possible, et ce sur une plage de déphasage la plus large possible.

D'autres critères requis pour ce type d'application consistent en une réduction aussi poussée que possible de la consommation de ces circuits élémentaires ainsi qu'en une adaptation en impédance de ces circuits élémentaires, rendant possible leur mise en cascade directe avec d'autres circuits, sans utiliser de circuits isolateurs intermédiaires.

Les déphaseurs de signaux hyperfréquence existants se classent en deux catégories :
- les déphaseurs analogiques qui peuvent fournir une variation continue du déphasage en agissant sur une tension de commande,
- les déphaseurs numériques qui fournissent une variation du déphasage par pas ayant une valeur prédéterminée fixe.

Les déphaseurs numériques sont parfaitement réalisables en technologie intégrée monolithique, répondant ainsi à l'objectif de miniaturisation mentionné plus haut mais, ainsi qu'il vient d'être vu, ils ne permettent pas un réglage suffisamment fin du déphasage.

Les déphaseurs analogiques se classent eux-mêmes en plusieurs catégories :
- les déphaseurs dits à modulation vectorielle, dont le principe consiste à diviser le signal d'entrée en quatre quarts égaux tous déphasés de 90°, afin de créer quatre vecteurs orthogonaux de même amplitude; ensuite, chacun de ces vecteurs est atténué par un atténuateur variable, puis les quatre signaux ainsi obtenus sont recombinés et le signal de sortie résultant présente par rapport au signal d'entrée un déphasage donné qui dépend donc des valeurs des quatre atténuations qui ont été appliqués. Les inconvénients de cette solution viennent de la complexité du circuit (nécessitant trois diviseurs, quatre atténuateurs, trois combineurs), du manque de précision sur le déphasage final et surtout du fait que la consommation en puissance continue de ce circuit est loin d'être négligeable, le rendant tout à fait inadapté pour des applications spatiales.
- les déphaseurs dits par réflexion, dont le principe consiste à diviser le signal d'entrée sur les voies directes et couplées d'un coupleur hybride 3dB (du type "coupleur de Lange"). Des cellules L-C (formées d'inductances et de condensateurs à capacité variable constitués par des diodes varactors) identiques et placés sur ces mêmes voies réfléchissent les signaux qui se recombinent en sortie avec un certain déphasage. Le principal inconvénient de cette topologie réside dans la grande surface occupée par ce circuit qui le rend assez difficile à intégrer en technologie monolithique.
- les déphaseurs basés sur la variation de l'angle du coefficient de transmission d'un transistor contre-réactionné à l'aide d'une réactance variable.

Un déphaseur de ce type est décrit dans le document : 18th European Microwave Conférence - Stockholm - 1988 "A novel microwave transmission phase - shifter" J.P. Coupez, R.A. Perichon. La réactance variable est formée par la mise en série d'une inductance et d'un condensateur à capacité variable constitué, pour permettre une réalisation en circuit intégré monolithique, par une diode varactor. Ce déphaseur ne comporte cependant pas de circuits d'adaptation, d'entrée et de sortie, associés, ce qui en pratique lui confère des performances très médiocres.

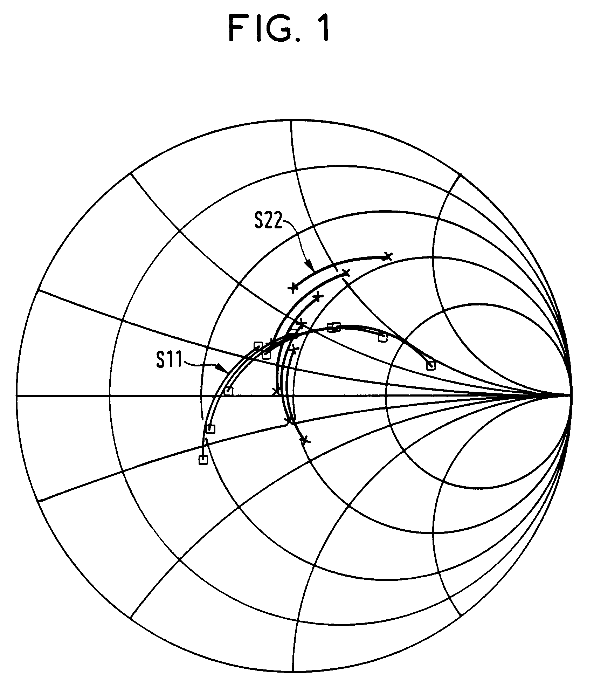

On a ainsi illustré sur la figure 1, sous forme d'abaque de Smith, différentes valeurs du coefficient de réflexion d'entrée S11 et du coefficient de réflexion de sortie S22 d'un tel déphaseur, sans circuits d'adaptation d'entrée et de sortie. Ces différentes valeurs sont obtenues pour un ensemble de valeurs de la tension de commande des diodes varactors formant les condensateurs à capacité variable (en l'occurrence cinq valeurs), et, pour chacune de ces valeurs, en faisant en outre varier la fréquence sur une certaine plage de variation, ce qui conduit, pour la loi de variation desdits coefficients de réflexion, à un ensemble d'arcs de courbes tels qu'illustrés sur la figure 1.

La présente invention a pour objet de tels circuits d'adaptation d'entrée et de sortie, qui soient efficaces sur toute la plage de variation de la réactance de contre-réaction du transistor, pour une plage de fréquences de fonctionnement donnée.

La présente invention est basée sur l'observation d'une analogie entre la loi de variation des coefficients de réflexion d'entrée et de sortie d'un tel circuit déphaseur lorsqu'on fait varier ladite réactance, et la loi de

2

variation des coefficients de réflexion d'entrée et de sortie d'un amplificateur large bande lorsqu'on fait varier sa fréquence de fonctionnement, cette observation autorisant la reprise, pour le premier cas, d'une solution utilisée dans le deuxième cas et qui sera décrite dans ce qui suit.

La présente invention a pour objet un déphaseur variable analogique pour signaux hyperfréquence, essentiellement caractérisé en ce qu'il comporte un circuit déphaseur proprement dit, comportant lui-même un transistor contre-réactionné au moyen d'une réactance variable, et des circuits actifs d'adaptation d'entrée et de sortie réalisant une telle adaptation sur toute la plage de variation de ladite réactance variable, et étant du type utilisé pour réaliser une adaptation d'un amplificateur de signaux hyperfréquence à large bande, sur toute la plage de variation de fréquence des signaux hyperfréquence appliqués à cet amplificateur.

D'autres objets et caractéristiques de la présente invention apparaîtront à la lecture de la description suivante d'un exemple de réalisation, faite en relation avec les dessins ci-annexés dans lesquels, outre la figure 1 déjà décrite,

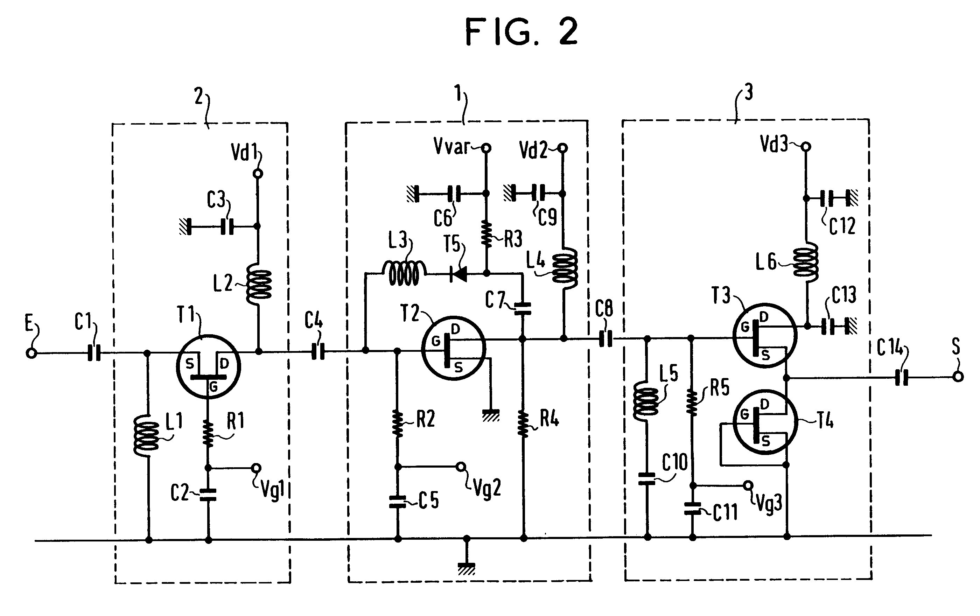

- la figure 2 est un schéma électrique d'un déphaseur suivant l'invention, muni de circuits actifs d'adaptation, d'entrée et de sortie.

Le schéma de la figure 2 est réalisable en technologie intégrée monolithique. Il comporte un circuit déphaseur proprement dit, référencé 1, un circuit actif d'adaptation d'entrée, référencé 2, et un circuit actif d'adaptation de sortie, référencé 3.

Le circuit déphaseur proprement dit 1 comporte essentiellement, dans cet exemple :

- un transistor à effet de champ T2 monté en source commune,
- un circuit de contre-réaction du drain D sur la grille G du transistor T2, ce circuit de contre-réaction comportant lui-même en série une inductance L3 et une diode varactor constituée d'un transistor T5 à effet de champ ayant drain et source court-circuités, un condensateur C7 servant en outre à découpler la diode varactor du drain du transistor T2,
- des éléments de connexion et/ou de polarisation de la grille G du transistor T2 : source de tension continue Vg2, résistance R2 (connectée entre G et Vg2) et condensateur C5 (connecté entre le point commun à R2 et Vg2, et la masse),
- des éléments de connexion et/ou de polarisation du drain D du transistor T2 : source de tension continue Vd2, résistance R4 (connectée entre D et la masse), inductance L4 (connectée entre D et Vd2), condensateur C9 (connecté entre le point commun à L4 et Vd2 et la masse),
- des éléments de connexion et/ou de polarisation de la grille G du transistor T5 : source de tension continue variable Vvar, résistance R3 (connectée entre Vvar et la grille du transistor T5) et condensateur C6 (connecté entre le point commun à R3 et Vvar et la masse).

Les résistances R2 et R4 servent en outre à stabiliser le transistor T2.

Le circuit actif d'adaptation d'entrée 2 comporte essentiellement, dans cet exemple :

- un transistor à effet de champ T1, monté en grille commune,
- des éléments de connexion et/ou de polarisation de la grille G du transistor T1 : source de tension continue Vg1, résistance R1 (connectée entre G et Vg1), et condensateur C2 (connecté entre le point commun à R1 et Vg1 et la masse),
- des éléments de connexion et/ou de polarisation de la source S du transistor T1 : inductance L1 (connectée entre S et la masse),
- des éléments de connexion et/ou de polarisation du drain D du transistor T1 : source de tension continue Vd1, inductance L2 (connectée entre D et Vd1), condensateur C3 (connecté entre le point commun à L2 et Vd1 et la masse).

Les inductances L1 et L2 permettent d'améliorer l'adaptation réalisée par ce transistor T1 monté en grille commune.

Enfin sont prévus en entrée et en sortie de ce circuit d'adaptation d'entrée des condensateurs de découplage, respectivement C1 et C4.

Le circuit actif d'adaptation de sortie 3 comporte essentiellement, dans l'exemple considéré :

- un transistor à effet de champ T3 monté en drain commun ou "suiveur de source",
- des éléments de connexion et/ou de polarisation de la grille G du transistor T3 : source de tension continue Vg3, résistance R5 (connectée entre G et Vg3) condensateur C11 (connecté entre le point commun à Vg3 et R5, et la masse) inductance L5 et condensateur C10 (connectés en série entre G et la masse),
- des éléments de connexion et/ou de polarisation de drain D du transistor T3 : source de tension continue Vd3, inductance L6 (connectée entre D et Vd3), condensateur C12 (connecté entre le point commun à Vd3 et L6, et la masse) et condensateur C13 (connecté entre D et la masse),
- des éléments de connexion et/ou de polarisation de la source S du transistor T3, comportant eux-mêmes en l'occurrence une charge active connectée entre la source S du transistor T3 et la masse, cette charge active étant constituée d'un transistor à effet de champ T4 ayant grille et source court-circuitées et mises à la masse, permettant de présenter une impédance très faible en continu (afin de réduire la consommation de ce circuit) et une impédance très forte en hyperfréquences.

L'inductance parallèle L5, placée sur la grille du transistor T3, permet d'améliorer l'adaptation réalisée par ce transistor monté en "suiveur de source".

Enfin sont prévues en entrée et en sortie de ce circuit d'adaptation de sortie des capacités de découplage, respectivement C8 et C14.

Le circuit actif d'adaptation d'entrée 2 permet à l'ensemble formé par le déphaseur 1 et par le circuit d'adaptation de sortie 3 de présenter une impédance d'entrée égale à 50Ω et une impédance de sortie conjuguée de l'impédance d'entrée de l'ensemble formé par le déphaseur 1 et par le circuit d'adaptation de sortie 3.

Le circuit actif d'adaptation de sortie 3 permet à l'ensemble formé par le déphaseur 1 et par le circuit d'adaptation d'entrée 2 de présenter une impédance de sortie égale à 50Ω et une impédance d'entrée conjuguée de l'impédance de sortie de l'ensemble formé par le déphaseur 1 et par le circuit d'adaption d'entrée 2.

Lesdites valeurs d'impédance souhaitées sont obtenues par un dimensionnement adéquat des éléments formant lesdits circuits d'adaptation.

En particulier, l'utilisation de la technologie monolithique micro-onde (MMIC) permet d'ajuster la taille des transistors T1, T3, T4 afin d'optimiser les adaptations d'entrée et de sortie du circuit.

Dans l'exemple de réalisation décrit, les transistors T1, T2, T3, T4 sont des transistors à effet de champ. Il pourrait cependant s'agir de transistors bipolaires ; pour englober les différents cas possibles, on utilisera le terme d'électrode de commande pour désigner la grille dans le cas d'un transistor à effet de champ, ou la base dans le cas d'un transistor bipolaire, et le terme d'électrodes de transfert pour désigner le drain et la source dans le cas d'un transistor à effet de champ, ou le collecteur et l'émetteur dans le cas d'un transistor bipolaire.

A titre d'exemple non limitatif les composants intervenant dans le schéma de la figure 2 peuvent avoir les valeurs suivantes :

| C1 = 0.6pF | C8 = 6pF | L1 = 0.9nH | R1 = 5k |
| C2 = 10pF | C9 = 10pF | L2 = 2.8nH | R2 = 2.5k |
| C3 = 10pF | C10 = 10pF | L3 = 1.2nH | R3 = 5k |
| C4 = 10pF | C11 = 10pF | L4 = 5nH | R4 = 1k |
| C5 = 10pF | C12 = 10pF | L5 = 0.7nH | R5 = 5k |
| C6 = 10pF | C13 = 10pF | L6 = 5nH | |
| C7 = 10pF | C14 = 10pF | | |

**Revendications**

1. Déphaseur variable analogique pour signaux hyperfréquence, caractérisé en ce qu'il comporte un circuit déphaseur proprement dit (1), comportant lui-même un transistor (T2) contre-réactionné au moyen d'une réactance variable (L3, T5), et des circuits actifs d'adaptation d'entrée (2) et de sortie (3) réalisant une telle adaptation sur toute la plage de variation de ladite réactance variable, et étant du type utilisé pour réaliser une adaptation d'un amplificateur de signaux hyperfréquence à large bande, sur toute la plage de variation de fréquence des signaux hyperfréquence appliqués à cet amplificateur.

2. Déphaseur selon la revendication 1, caractérisé en ce que le circuit actif d'adaptation d'entrée comporte un transistor (T1) monté avec son électrode de commande commune et ses électrodes de transfert assurant la liaison d'une part avec l'entrée (E) dudit déphaseur, d'autre part avec ledit transistor contre-réactionné (T2).

3. Déphaseur selon l'une des revendications 1 et 2, caractérisé en ce que le circuit actif d'adaptation de sortie comporte un transistor (T3) monté en suiveur de source et ayant son électrode de commande reliée audit transistor contre-réactionné, et son électrode de transfert non commune mise à la masse par l'intermédiaire d'une charge active présentant une très faible impédance en continu et une très forte impédance en hyperfréquence, la sortie (S) dudit déphaseur étant prise sur ladite électrode de transfert non commune.

4. Déphaseur selon la revendication 3, caractérisé en ce que ladite charge active comporte un transistor (T4) monté avec une de ses électrodes de transfert reliée à l'électrode de transfert non commune dudit transistor monté en suiveur de source, et son électrode de commande et son autre électrode de transfert court-circuitées et mises à la masse.

5. Déphaseur selon l'une des revendications 1 à 4, caractérisé en ce qu'il est réalisé sous forme de circuit intégré en technologie monolithique micro-onde.

# FIG. 1

FIG. 2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| Y | UNIVERSITE DU LANGUEDOC, FR, 6ES JOURNEES NATIONALES MICROONDES 21 Juin 1989, MONTPELLIER, FR pages 25 - 26; COUPEZ ETAL: 'Une Solution pour les Systemes de Communications Grand Public Autour de' * page 25, ligne 42 - page 26, ligne 11; figures 2,3 * | 1,2 | H03H11/20 |
| Y | PATENT ABSTRACTS OF JAPAN vol. 13, no. 513 (E-847)16 Novembre 1989 & JP-A-01 208 908 ( KENKYUSHO ) 22 Août 1989 * le document en entier * | 1,2 | |
| A | EP-A-0 401 632 (ROCKWELL) * page 6, ligne 21 - ligne 53 * * page 7, ligne 17 - ligne 39; figures 2,3 * | 1,3 | |
| A | HOROWITZ ETAL 'The Art of Electronics' 1980 , UNIVERSITY OF CAMBRIDGE , CAMBRIDGE, GB * page 235, colonne de droite, ligne 21 - page 236, colonne de gauche, ligne 16; figures 6.20 * | 3,4 | |

DOMAINES TECHNIQUES RECHERCHES (Int. Cl.5 )

H03H

Le présent rapport a été établi pour toutes les revendications

| Lieu de la recherche | Date d'achèvement de la recherche | Examinateur |
|---|---|---|
| LA HAYE | 13 MAI 1992 | WRIGHT J.P. |